# EUROPÄISCHE PATENTSCHRIFT

(11) **EP 2 267 798 B1**
(45) Veröffentlichungstag und Bekanntmachung des Hinweises auf die Patenterteilung: **30.09.2015**
(21) Anmeldenummer: 10181078.6
(22) Anmeldetag: 27.07.1998
(51) Int. Cl.: H01L 33/48, H01L 25/075, H01L 33/62, H01L 33/64

(54) **Optoelektronisches Bauelement**
Optoelectronic device
Dispositif opto-électronique

(30) Priorität: 29.07.1997 DE 19732646
(43) Veröffentlichungstag der Anmeldung: 29.12.2010
(62) Teilanmeldung aus: 05011759.7
(73) Patentinhaber: OSRAM Opto Semiconductors GmbH, 93055 Regensburg (DE)
(72) Erfinder: Arndt, Karlheinz, 93077 Bad Abbach (DE)
(74) Vertreter: Epping - Hermann - Fischer

(56) Entgegenhaltungen:
- EP-A1- 0 468 341
- DE-A1- 19 536 454
- JP-A- 4 163 973
- JP-A- 6 204 604
- US-A- 5 146 310
- US-A- 5 564 819

## Beschreibung

Die Erfindung bezieht sich auf ein optoelektronisches Bauelement, bei dem ein optoelektronischer Chip mittels eines gut wärmeleitenden Verbindungsmittels auf einem Chipträgerteil eines Leiterrahmens (Leadframe) befestigt ist, der Leiterrahmen einen in einem Abstand zum Chipträgerteil angeordneten, mit einem elektrischen Kontakt des Chips elektrisch leitend verbundenen Anschlussteil aufweist, und bei dem der Chip und zumindest jeweils ein Teilbereich des Chipträgerteiles und des Anschlussteiles von einer Umhüllung umgeben sind, derart, dass für eine Leiterplattenmontage bestimmte, im Leiterrahmen vorgesehene externe Anschlüsse des Chipträgerteiles und des Anschlussteiles aus der Umhüllung herausragen oder vollständig außerhalb der Umhüllung liegen. Sie bezieht sich im Speziellen auf ein optoelektronisches Bauelement mit einem optoelektronischen Halbleiterchip, insbesondere mit einem bei hoher Leistung betriebenen Leuchtdioden(LED)-Chip.

Ein solches Bauelement ist beispielsweise aus der europäischen Patentanmeldung EP 400 176 bekannt. Hierin ist eine sogenannte TOPLED beschrieben, bei der ein lichtemittierender Halbleiterchip (LED-Chip) auf einem ebenen Chipträgerteil eines Leiterrahmens befestigt ist. Der Leiterrahmen setzt sich zusammen aus dem Chipträgerteil und einem in einem Abstand zu diesem, also elektrisch isoliert von diesem angeordneten Anschlussteil mit jeweils einem externen Anschluss. Der Chipträgerteil mit dem Halbleiterchip, der Anschlussteil und Teilbereiche der externen Anschlüsse sind von einer Umhüllung umgeben, die aus einem strahlungsundurchlässigen Grundkörper mit einer Ausnehmung und einem diese Ausnehmung ausfüllenden strahlungsdurchlässigen Fensterteil besteht. Der Chipträgerteil und der Anschlussteil sind derart von dem Grundkörper umgeben bzw. in diesen eingebettet, dass Teilbereiche der Oberseiten des Chipträgerteils und des Anschlussteils mit der verbleibenden Bodenfläche der Ausnehmung bündig abschließen. Der Halbleiterchip ist bis auf seine Unterseite, mit der er auf dem Chipträgerteil aufliegt, vollständig von dem strahlungsdurchlässigen Fensterteil umgeben. Die Ausnehmung und deren Innenflächen sind derart geformt und angeordnet, dass sie für die vom Halbleiterchip ausgesandte Strahlung einen im Wesentlichen kegelstumpfförmigen Reflektor bildet.

In der DE 19536454A1 ist ein optoelektronisches Bauelement beschrieben, bei dem zur Verbesserung der Wärmeableitung vom Halbleiterchip zwei externe Anschlüsse des Chipträgerteiles des Leiterrahmens gegenüber den externen Anschlüssen des Anschlußteiles verbreitert sind.

Bei den oben beschriebenen bekannten optoelektronischen Bauelementen kommt es bei Betrieb des Halbleiterchips bei hohen Strömen und damit bei hoher Leistung, wie es beispielsweise bei sogenannten Power-LEDs der Fall ist, aufgrund von unzureichender Wärmeableitung vom Halbleiterchip, zu dessen starker Erhitzung. Diese Erhitzung führt häufig zur Beeinträchtigung der Funktionsfähigkeit des Halbleiterchips, wie z. B. beschleunigte Alterung, Abbrechen des Halbleiterchips vom Leiterrahmen, Abbrechen der Bonddrähte oder Zerstörung des Chips. Die bekannten verbreiterten externen Anschlüsse des Chipträgerteiles begünstigen eine Delamination des Kunststoffes vom Leiterrahmen, die z. B. ein Eindringen von Feuchtigkeit zum Halbleiterchip hervorrufen kann.

In der Druckschrift JP 06-204 604 A ist ein Halbleiterlaserbauteil angegeben.

Die Druckschrift US 5,564,819 A betrifft Leuchtdioden und eine Anordnung von Leuchtdioden zum Anbringen an einem Substrat.

Der Erfindung liegt daher die Aufgabe zugrunde, das optoelektronische Bauelement der eingangs genannten Art so weiterzubilden, dass eine verbesserte Wärmeableitung vom Chip gewährleistet ist, ohne gleichzeitig die Gehäuseabmessungen wesentlich zu verändern und ohne gleichzeitig die Delaminationsgefahr wesentlich zu erhöhen.

Diese Aufgabe wird durch ein Bauelement mit den Merkmalen des Anspruches 1 gelöst.

Vorteilhafte Weiterbildungen der erfindungsgemässen Bauelemente sind Gegenstand der Unteransprüche 2 bis 12.

Es ist ein Bauelement mit mindestens einem ersten und einem zweiten optoelektronischen Chip vorgesehen, und so weist erfindungsgemäß der Chipträgerteil mindestens zwei externe Anschlüsse auf, die an verschiedenen einen Abstand voneinander aufweisenden Stellen der Umhüllung aus dieser herausragen. Der Leiterrahmen weist hier mindestens zwei Anschlussteile mit jeweils einem externen Anschluss auf, die ebenfalls seitlich aus der Umhüllung herausragen. Bevorzugt sind auch hier die externen Anschlüsse des Chipträgerteiles und der Anschlussteile in Draufsicht auf den Leiterrahmen gesehen im Wesentlichen sternförmig angeordnet, wodurch ein maximaler Abstand der externen Anschlüsse des Chipträgerteiles voneinander gewährleistet ist. Die im Betrieb des Bauelements über den Chipträgerteil und dessen externen Anschlüsse vom Chip abgeleitete thermische Energie wird dadurch an verhältnismäßig weit voneinander entfernten Punkten in die Leiterplatte eingespeist, so dass auch hier eine sehr gute Wärmeverteilung auf der Leiterplatte erzielt wird.

Besonders bevorzugt sind bei dem letztgenannten Bauelement die externen Anschlüsse des Chipträgerteiles in Draufsicht auf den Leiterrahmen gesehen bezüglich des Chipträgerteiles diagonal versetzt zueinander angeordnet. Sie ragen auf einander gegenüberliegenden Seitenflächen einer vorzugsweise im Wesentlichen quaderförmigen Umhüllung aus dieser heraus. Die Anschlussteile sind hierbei auf verschiedenen Seiten des Chipträgerteiles angeordnet und deren externe Anschlüsse ragen ebenfalls auf einander gegenüberliegenden Seitenflächen der Umhüllung aus dieser heraus. In Draufsicht auf den Leiterrahmen sind sie bezüglich des Chipträgerteiles zu den externen Anschlüssen des Chipträgerteiles zueinander entgegengesetzt diagonal versetzt angeordnet.

Um die Wärmeableitung von den Chips, falls notwendig, weiter zu verbessern, kann der Chipträgerteil auch mehr als zwei externe Anschlüsse aufweisen, die wiederum an verschiedenen einen Abstand von einander aufweisenden Stellen der Umhüllung aus dieser herausragen. Die Anzahl dieser externen Anschlüsse kann nach Bedarf je nach zulässiger Baugröße des Bauelements weiter erhöht werden.

Bei einem erfindungsgemäßen Bauelement, das so auf einer Leiterplatte befestigt werden kann, dass bei dessen Betrieb die die vom Chip ausgesandte Strahlung im Wesentlichen parallel zur Leiterplatte abgestrahlt wird (seitlich emittierendes Bauelement), weist der Chipträgerteil mindestens zwei externe Anschlüsse und der Anschlussteil mindestens einen externen Anschluss auf, die getrennt voneinander an ein- und derselben Seitenfläche der Umhüllung aus dieser herausragen. Der externe Anschluss des Anschlussteiles ist hierbei bevorzugt zwischen den beiden externen Anschlüssen des Chipträgerteiles angeordnet.

Bei einer besonders bevorzugten Weiterbildung des letztgenannten Bauelements ist der externe Anschluss des Anschlussteiles schmäler als die beiden externen Anschlüsse des Chipträgerteiles. Selbstverständlich können optional auch bei den anderen oben genannten erfindungsgemäßen Bauelementen die externen Anschlüsse des Chipträgerteiles breiter sein als die externen Anschlüsse der Anschlussteile.

Bei einer Weiterbildung des oben genannten seitlich emittierenden Bauelements ist der Chipträgerteil zusätzlich mit mindestens einer Kühlfahne wärmeleitend verbunden, die auf einer anderen Seitenfläche der Umhüllung als die Anschlussteile aus dieser herausragt. Diese Kühlfahne alleine oder eine an diese Kühlfahne thermisch angeschlossene weitere Kühleinrichtung gewährleistet eine weiter verbesserte Wärmeableitung vom Chip.

Weitere Vorteile und bevorzugte Ausführungsformen ergeben sich aus den im folgenden in Verbindung mit den Figuren 1 bis 3b näher erläuterten Beispielen, die nicht alle Ausführungsbeispiele der Erfindung sind.

Es zeigen:
Figur 1a eine schematische Darstellung einer Draufsicht eines erläuternden Beispiels eines Bauelements mieinem einzigen optoelektronischen Chip,
Figur 1b eine schematische Darstellung eines Schnittes durch das erläuternde Beispiel von Figur 1 entlang der Linie A-A,
Figur 2 eine schematische Darstellung einer Draufsicht eines Ausführungsbeispieles eines erfindungsgemäßen Bauelements mit mindestens zwei optoelektronischen Chips,
Figur 3a eine schematische Darstellung einer Seitenansicht eines erläuternden Beispiels eines seitlich emittierenden Bauelements und
Figur 3b eine schematische Darstellung eines Schnittes durch das erläuternde Beispiel von Figur 3 entlang der in Figur 3 eingezeichneten Linie A-A.

In den Figuren sind gleiche und gleichwirkende Bestandteile der verschiedenen Beispiele immer mit denselben Bezugszeichen versehen.

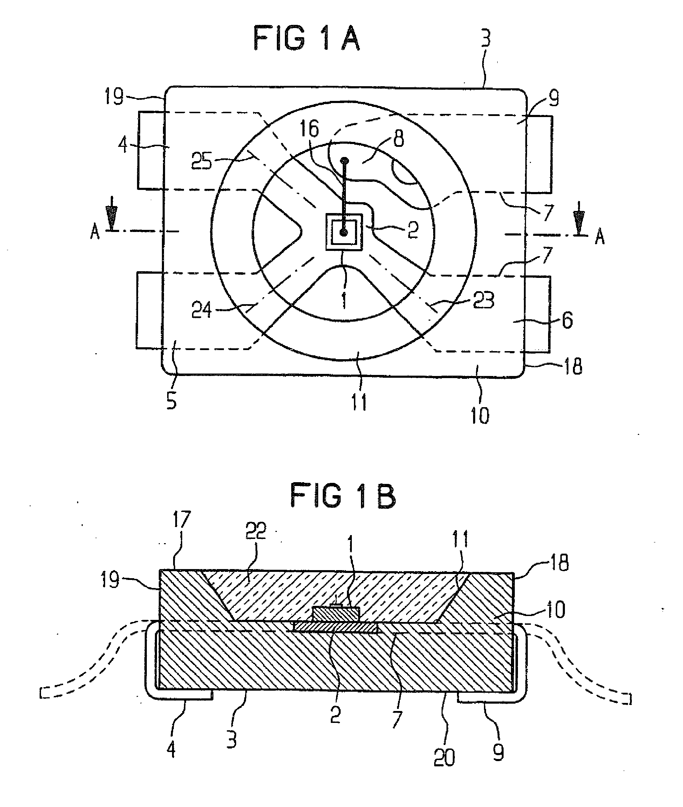

Bei dem Bauelement gemäß Figur 1 handelt es sich um ein Leuchtdioden-Bauelement, das nicht unter die Erfindung fällt, bei dem auf einem Chipträgerteil 2 eines Leiterrahmens (Leadframe) 7 ein lichtemittierender Halbleiterchip 1 (LED-Chip) mittels eines gut wärmeleitenden Verbindungsmittels, z. B. mittels eines metallischen Lotes befestigt ist. Drei separate externe Anschlüsse 4, 5, 6 erstrecken sich ausgehend vom Chipträgerteil 2 in drei verschiedene Richtungen nach außen. In einem Abstand zum Chipträgerteil 2 mit den externen Anschlüssen 4, 5, 6 ist ein Anschlussteil 8 mit einem externen Anschluss 9 angeordnet, der mittels eines Bonddrahtes 16 mit einem elektrischen Kontakt des LED-Chips 1, z. B. mit der Anodenkontaktierung verbunden ist. Eine zweite Kontaktmetallisierung (Kathodenkontaktierung) des LED-Chips 1 befindet sich beispielsweise an dessen dem Chipträgerteil 2 zugewandten Unterseite und ist mit dem Chipträgerteil 2 mittels dem in diesem Fall auch elektrisch leitenden Verbindungsmittel elektrisch leitend verbunden. Der Chipträgerteil 2 mit den externen Anschlüssen 4, 5, 6 dient folglich in diesem Fall sowohl als Kathodenanschluss als auch als thermischer Anschluß zur Wärmeableitung vom LED-Chip.

Ist die Kathodenkontaktierung nicht, wie im oben genannten Fall, an der Unterseite des Chips 1 angeordnet, sondern z. B. an dessen Oberseite, kann diese mittels eines Bonddrahtes mit dem Chipträgerteil 2 elektrisch leitend verbunden sein.

Der Chipträgerteil 2, der Anschlussteil 8 und Teilbereiche von deren externen Anschlüsse 4, 5, 6, 9 sind von einem im Wesentlichen quaderförmigen Grundkörper 10 einer Umhüllung 3 umschlossen, der eine Ausnehmung 11 aufweist. Die Ausnehmung 11 hat im Wesentlichen die Form eines Kegelstumpfes und reicht von einer zum Leiterrahmen 7 parallel liegenden Hauptfläche 17 des Grundkörpers 10 bis zum Leiterrahmen 7, wobei sich der Querschnitt der Ausnehmung 11 vom Leiterrahmen 7 zur Hauptfläche 17 des Grundkörpers 10 hin vergrößert. Der LED-Chip 1 befindet sich in der Ausnehmung 11, die mit einem strahlungsdurchlässigen Fensterteil 22, bevorzugt mit einem transparenten Kunststoffverguss versehen ist. Dieser Fensterteil 22 bildet zusammen mit dem Grundkörper 10 eine Umhüllung 3 des Bauelements. Die externen Anschlüsse 4, 5, 6, 9 ragen auf einander gegenüberliegenden Seitenflächen 18,19 des Grundkörpers 10 aus diesem heraus. Sie verlaufen innerhalb des Grundkörpers 10 ausgehend von dem Chipträgerteil 2 zunächst im Wesentlichen sternförmig auseinander und knicken im weiteren Verlauf ab, derart, dass sie die Seitenflächen 18,19 senkrecht durchdringen.

Der Chipträgerteil 2 liegt bevorzugt vollständig innerhalb der Bodenfläche der Ausnehmung 11.

Die externen Anschlüsse 4,5,6,9 weisen in dem Bereich, in dem sie sternförmig nach außen verlaufen, Längsmittelachsen 23,24,25 auf, von denen jeweils zwei zueinander benachbarte einen Winkel von etwa 90° einschließen.

Die externen Anschlüsse 4, 5, 6, 9 sind außerhalb des Grundkörpers 10 zunächst zu der der ersten Hauptfläche 17 gegenüberliegenden zweiten Hauptfläche 20 des Grundkörpers 10 hin und im weiteren Verlauf unterhalb des Grundkörpers 10 zu dessen Mitte hin gebogen. Sie können aber auch, wie in Figur 1b gestrichelt angedeutet, zu schwingenförmigen Anschluss-Stummeln gebogen sein. Auch dies stellt eine an sich in der Oberflächenmontage-Technik übliche Form der externen elektrischen Anschlüsse dar. Diese Arten von externen Anschlüssen für oberflächenmontierbare Bauelemente (SMD) sind an sich bekannt und werden von daher an dieser Stelle nicht näher erläutert.

Die externen Anschlüsse sind folglich derart geformt, daß sie im auf einer für die Montage des Bauelements vorgesehenen Leiterplatte montierten Zustand des Bauelements alle gleichzeitig auf der Anschluß- oder Leiterplatte aufliegen.

Die Innenflächen der Ausnehmung 11 bilden einen Reflektor für die vom LED-Chip 1 im Betrieb des Bauelements ausgesandte Strahlung. Sie sind optional mit einem reflexionssteigernden Material beschichtet. Alternativ kann der Grundkörper aus einem reflexionssteigernden Material bestehen.

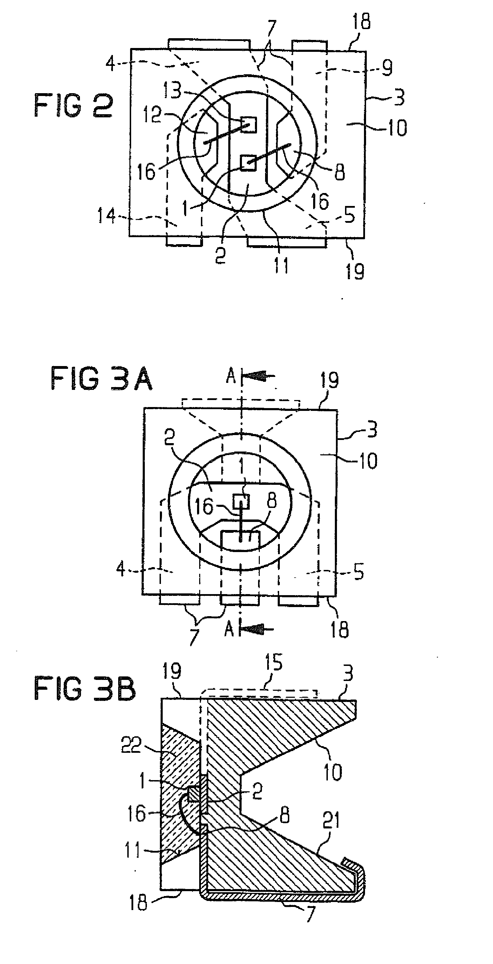

Bei dem Ausführungsbeispiel von Figur 2 sind im Unterschied zum erläuternden Beispiel der Figuren 1a und 1b auf einem Chipträgerteil 2 eines Leiterrahmens 7 zwei verschiedenfarbig leuchtende LED-Chips 1, 13 mittels eines thermisch und elektrisch leitenden Verbindungsmittels befestigt. Auf gegenüberliegenden Seiten des Chipträgerteiles 2 sind in einem Abstand zu diesem ein erster 8 und ein zweiter Anschlussteil 12 angeordnet, von denen jeder einen externen Anschluss 9,14 aufweist. Diese externen Anschlüsse 9,14 verlaufen parallel versetzt zueinander, erstrecken sich, gesehen vom Chipträgerteil 2, in zueinander entgegengesetzten Richtungen und ragen auf einander gegenüberliegenden Seitenflächen 18,19 des Grundkörpers 10 aus diesem heraus. Sie sind mittels Bonddrähten 16 mit den Anodenkontaktierungen der LED-Chips 1,13 elektrisch leitend verbunden.

Das Chipträgerteil 2 weist zwei externe Anschlüsse 4,5 auf, die sich ausgehend vom Chipträgerteil 2 im Wesentlichen ebenfalls parallel versetzt zueinander in zueinander entgegengesetzten Richtungen parallel zu den externen Anschlüssen 9,14 der Anschlussteile 8,12 erstrecken und auf einander gegenüberliegenden Seitenflächen 18,19 des Grundkörpers 10 aus diesem herausragen.

Wie beim erläuternden Beispiel der Figuren 1a und 1b weist der strahlungsundurchlässige Grundkörper 10 eine kegelstumpfförmigen Ausnehmung 11 auf, die mit einem transparenten Fensterteil 22 versehen ist. Die LED-Chips 1,13 befinden sich in dieser der Ausnehmung 11.

Die externen Anschlüsse 4,5,9,14 ragen auf einander gegenüberliegenden Seitenflächen 18,19 des Grundkörpers 10 aus diesem heraus. Sie sind außerhalb des Grundkörpers 10 analog zum erläuternden Beispiel gemäß Figuren 1a und 1b geformt. Bei den oben beschriebenen Beispielen sind jeweils die Umhüllung 3 und die externen Anschlüsse 4,5,6,9,14 derart ausgebildet, dass im Betrieb des Bauelements die vom bzw. von den LED-Chip/s ausgesandte Strahlung im Wesentlichen senkrecht zur Montageoberfläche einer für die Montage des Bauelements vorgesehenen Leiterplatte abgestrahlt wird.

Bei dem erläuternden Beispiel der Figur 3a und 3b handelt es sich um ein sogenanntes seitlich emittierendes LED-Bauelement. Diese Art von Bauelement ist im allgemeinen Teil der Beschreibung bereits erläutert. Die Umhüllung 3 und die externen Anschlüsse 4,5 und 9 des Chipträgerteiles 2 bzw. des Anschlussteiles 8 sind bei diesem Bauelement derart ausgebildet, dass es mit einer Seitenfläche 20 des Grundkörpers 10 zur Montagefläche einer Leiterplatte hin auf dieser befestigt werden kann.

Hierzu weist ein Leiterrahmen 7 einen Chipträgerteil 2 auf, der mindestens zwei externe Anschlüsse 4,5 besitzt. Diese externen Anschlüsse 4,5 erstrecken sich zunächst ausgehend vom Chipträgerteil 2, auf dem ein LED-Chip 1 mittels eines thermisch und elektrisch leitenden Verbindungsmittels befestigt ist, in im Wesentlichen entgegengesetzten Richtungen nach außen. Im weiteren Verlauf knicken sie in dieselbe Richtung ab, so dass sie anschließend parallel zueinander in die gleiche Richtung verlaufen. Zwischen den beiden externen Anschlüssen 4,5 des Chipträgerteiles 2 ist ein Anschlussteil 8 mit einem externen Anschluss 9 angeordnet, der parallel zu den beiden externen Anschlüssen 4,5 des Chipträgerteiles in dieselbe Richtung wie diese verläuft.

Der Chipträgerteil 2, dessen externe Anschlüsse 4,5, der Anschlussteil 8 und dessen externer Anschluss 9 sind analog zu den beiden oben beschriebenen Ausführungsbeispielen mit einem strahlungsundurchlässigen Grundkörper 10 umschlossen, der eine kegelstumpfförmige Ausnehmung 11 aufweist, in dem der LED-Chip 1 angeordnet ist. Die Ausnehmung 11 ist auch hier mit einem strahlungsdurchlässigen Fensterteil 22 versehen, der bevorzugt aus einem strahlungsdurchlässigen Kunststoff besteht. Die externen Anschlüsse 4,5,9 ragen auf ein- und derselben Seitenfläche 18 des Grundkörpers 10 aus diesem heraus, sind außerhalb des Grundkörpers 10 nach unten in Richtung Rückseite des Grundkörpers 10 gebogen und sind im weiteren Verlauf entlang der Rückseite 21 des Grundkörpers 10 zu dessen Mitte hin gebogen. Die von der Seitenfläche 18 des Grundkörper 10 abgewandten Außenflächen der externen Anschlüsse 4,5,9 bilden eine Auflagefläche des Bauelements zu dessen Montage auf einer Leiterplatte.

Zur zusätzlichen Kühlung des LED-Chips 1 kann der Chipträgerteil 2 mit einer Kühlfahne 15 aufweisen (in den Figuren 3a und 3b gestrichelt eingezeichnet). Diese ragt auf einer der Seitenfläche 18, aus dem die externen Anschlüsse 4,5,9 herausragen, gegenüberliegenden Seitenfläche 19 des Grundkörpers 10 aus diesem heraus und ist außerhalb des Grundkörpers 10 zu dessen Rückseite 21 hin gebogen, derart, dass sie auf der Seitenfläche 19 aufliegt. An diese Kühlfahne 15 können optional weitere Kühleinrichtungen thermisch angeschlossen werden.

Bei allen oben beschriebenen Beispielen sind bevorzugt die externen Anschlüsse des Chipträgerteiles 2 breiter als die externen Anschlüsse des bzw. der Anschlussteile 8,12. Damit kann bei im Wesentlichen unveränderter Gehäuseabmessung ein weiter verbesserter Wärmeabtransport vom LED-Chip 1 erzielt werden. Die externen Anschlüsse 4,5,6,9,12 können aber auch alle dieselbe Breite haben.

Um eine weitere Verbesserung des Wärmeabtransports vom LED-Chip zu erreichen, sind auf einer für die Montage des Bauelements vorgesehenen Leiterplatte besonders große Löt-Pads vorgesehen. Diese sind ebenfalls sternförmig angeordnet und können so die vom LED-Chip abgeführte Wärme großflächig auf der Leiterplatte verteilen. Die Leadframes der beschriebenen Bauelemente führen die Wärme sternförmig vom LED-Chip zur Gehäuseaußenseite. Dadurch wird die Wärme an weit voneinander entfernt liegenden Punkten in die Platine eingespeist. Auf der Platine befinden sich bevorzugt um jeden Löt-Pad große, beispielsweise aus Kupfer bestehende Metallisierungen, die die Wärme auf der Leiterplatte verteilen. Der Wärmewiderstand der erfindungsgemäßen Gehäuse ist gegenüber dem Wärmewiderstand herkömmlicher LED-Gehäuse deutlich reduziert.

Bei den oben beschriebenen Gehäusen für LED-Chips handelt es sich um in der Halbleitertechnik bekannte Gehäuse für optoelektronische Bauelemente. Die besonderen Formen, die dazu verwendeten Materialien und Herstellverfahren werden von daher an dieser Stelle nicht mehr näher erläutert.

Die Beschreibung der Erfindung anhand der Beispiele ist selbstverständlich nicht als Einschränkung der Erfindung auf diese Beispiele zu verstehen.

## Patentansprüche

1. Optoelektronisches Bauelement, bei dem mindestens ein erster und mindestens ein zweiter optoelektronischer Chip (1,13) auf einem Chipträgerteil (2) eines Leiterrahmens (Leadframe) (7) befestigt sind, bei dem der Leiterrahmen (7) mindestens einen ersten und einen zweiten in einem Abstand zum Chipträgerteil (2) angeordneten Anschlussteil (8,12) aufweist, wobei der erste Anschlussteil (8) mit einem elektrischen Kontakt des ersten Chips (1) und der zweite Anschlussteil (12) mit einem elektrischen Kontakt des zweiten Chips (13) elektrisch leitend verbunden sind, und bei dem die optoelektronischen Chips (1,13) und jeweils zumindest ein Teilbereich des Chipträgerteiles (2) und der Anschlussteile (8,12) von einer Umhüllung (3) umgeben sind, derart, dass externe Anschlüsse (4,5,9,14) des Chipträgerteiles (2) und der Anschlussteile (8,12) aus der Umhüllung (3) herausragen, wobei der Chipträgerteil (2) mindestens zwei externe Anschlüsse (4,5) aufweist, die an verschiedenen einen Abstand voneinander aufweisenden Stellen der Umhüllung (3) aus dieser herausragen,
**dadurch gekennzeichnet,**
**dass** die Umhüllung (3) und die externen Anschlüsse (4,5,6,9,14) oberflächenmontierbar ausgebildet sind, und
**dass** die externen Anschlüsse (4,5,6,9,14) derart geformt sind, dass sie im auf einer für die Montage des Bauelements vorgesehenen Leiterplatte montierten Zustand des Bauelements alle gleichzeitig auf der Leiterplatte aufliegen.

2. Optoelektronisches Bauelement nach dem vorherigen Anspruch, bei dem der erste optoelektronische Chip (1) und der zweite optoelektronische Chip (13) dazu geeignet sind, verschiedenfarbig zu leuchten.

3. Optoelektronisches Bauelement nach einem der obigen Ansprüche, bei dem sich die externen Anschlüsse (4,5,9,14) des Chipträgerteiles (2) und der Anschlussteile (8,12) in Draufsicht auf den Leiterrahmen (7) gesehen vom Chipträgerteil (2) innerhalb der Umhüllung (3) getrennt voneinander im Wesentlichen sternförmig nach außen erstrecken.

4. Optoelektronisches Bauelement nach einem der obigen Ansprüche, bei dem die externen Anschlüsse (4,5) des Chipträgerteiles (2) im Wesentlichen zueinander parallel versetzt in entgegengesetzte Richtungen verlaufen und auf einander gegenüberliegenden Seitenflächen (18,19) der Umhüllung (3) aus dieser herausragen, bei dem die Anschlussteile (8,12) auf verschiedenen Seiten des Chipträgerteiles (2) angeordnet sind und bei dem deren externe Anschlüsse (9,14) parallel zu den externen Anschlüssen (4,5) des Chipträgerteiles (2) verlaufen und ebenfalls auf einander gegenüberliegenden Seitenflächen (18,19) der Umhüllung (3) aus dieser herausragen, so dass die externen Anschlüsse (4,5) des Chipträgerteiles (2) und die externen Anschlüsse (9,14) der Anschlussteile (8,12) jeweils diagonal versetzt zueinander angeordnet sind.

5. Optoelektronisches Bauelement nach einem der obigen Ansprüche, bei dem bei Betrieb der Chips (1, 13) eine von diesen ausgesandte Strahlung im Wesentlichen von einer Hauptfläche der Leiterplatte abgestrahlt bzw. empfangen wird.

6. Optoelektronisches Bauelement nach einem der obigen Ansprüche, das genau zwei in einem Abstand zum Chipträgerteil (2) angeordnete Anschlussteile (8,12) und genau zwei externe Anschlüsse (4,5) des Chipträgerteils (2) aufweist.

7. Optoelektronisches Bauelement nach einem der obigen Ansprüche, bei dem der externe Anschluss (9, 14) des Anschlussteiles (8, 12) schmäler als die externen Anschlüsse (4, 5, 6) des Chipträgerteiles (2) ist.

8. Optoelektronisches Bauelement nach einem der obigen Ansprüche, bei dem der Chipträgerteil (2) mit mindestens einer Kühlfahne (15) wärmeleitend verbunden ist, die auf einer anderen Seitenfläche (19) der Umhüllung (3) als die Anschlussteile (4,5,9) aus dieser herausragt.

9. Optoelektronisches Bauelement nach einem der obigen Ansprüche, bei dem die Umhüllung (3) vollständig aus einem strahlungsdurchlässigen Material besteht.

10. Optoelektronisches Bauelement nach einem der Ansprüche 1 bis 8, bei dem eine Ausnehmung (11) in der den Grundkörper (10) bildenden Umhüllung (3) vorgesehen ist, in der ein strahlungsdurchlässiges Fensterteil (12) angeordnet ist und bei dem der Chipträgerteil (2) von dem strahlungsundurchlässigen Grundkörper (10) teilweise umhüllt ist, wobei die Chips (1, 13) in der Ausnehmung (11) angeordnet sind.

11. Optoelektronisches Bauelement nach Anspruch 10, bei dem die Ausnehmung (11) in ihrem Verlauf von innerhalb der Umhüllung (3) nach außen im Querschnitt aufgeweitet ausgebildet ist.

12. Optoelektronisches Bauelement nach dem vorherigen Anspruch, bei dem die Innenfläche(n) der Ausnehmung (11) für die vom Chip (1, 13) ausgesandte Strahlung als Reflektor ausgebildet ist/sind.

## Claims

1. Optoelectronic component, in which at least one first and at least one second optoelectronic chip (1, 13) are fixed on a chip carrier part (2) of a leadframe (7), in which the leadframe (7) has at least one first and a second connection part (8, 12) which are arranged at a distance from the chip carrier part (2) wherein the first connection part (8) is electrically conductively connected to an electrical contact of the first chip (1) and the second connection part (12) is electrically conductively connected to an electrical contact of the second chip (13), and in which the optoelectronic chips (1, 13) and in each case at least a partial region of the chip carrier part (2) and of the connection parts (8, 12) are surrounded by an encapsulation (3) in such a way that external connections (4, 5, 9, 14) of the chip carrier part (2) and of the connection parts (8, 12) project from the encapsulation (3), wherein the chip carrier part (2) has at least two external connections (4, 5) which, at different mutually spaced apart locations of the encapsulation (3), project from the latter,
**characterized**
**in that** the encapsulation (3) and the external connections (4, 5, 6, 9, 14) are of surface-mountable design and in that the external connections (4, 5, 6, 9, 14) are shaped in such a way that, in the component state mounted on a printed circuit board provided for the mounting of the component, they all bear simultaneously on the printed circuit board.

2. Optoelectronic component according to the preceding claim, wherein the first optoelectronic chip (1) and the second optoelectronic chip (13) are suitable for emitting light in different colours.

3. Optoelectronic component according to either of the preceding claims, wherein the external connections (4, 5, 9, 14) of the chip carrier part (2) and of the connection parts (8, 12), as seen in a plan view of the leadframe (7), proceeding from the chip carrier part (2), extend outwards essentially in a star-shaped manner separately from one another within the encapsulation (3).

4. Optoelectronic component according to any of the preceding claims, wherein the external connections (4, 5) of the chip carrier part (2) essentially run parallel to one another in an offset manner in opposite directions and project from the encapsulation (3) on mutually opposite side areas (18, 19) of the said encapsulation, wherein the connection parts (8, 12) are arranged on different sides of the chip carrier part (2), and wherein the external connections (9, 14) thereof run parallel to the external connections (4, 5) of the chip carrier part (2) and likewise project from the encapsulation (3) on mutually opposite side areas (18, 19) of the said encapsulation, so that the external connections (4, 5) of the chip carrier part (2) and the external connections (9, 14) of the connection parts (8, 12) are in each case arranged diagonally offset with respect to one another.

5. Optoelectronic component according to any of the preceding claims, wherein, during operation of the chips (1, 13), a radiation that is emitted by the latter is emitted and/or received essentially by a main surface of the printed circuit board.

6. Optoelectronic component according to any of the preceding claims, which has exactly two connection parts (8, 12) arranged at a distance from the chip carrier part (2) and exactly two external connections (4, 5) of the chip carrier part (2).

7. Optoelectronic component according to any of the preceding claims, wherein the external connection (9, 14) of the connection part (8, 12) is narrower than the external connections (4, 5, 6) of the chip carrier part (2).

8. Optoelectronic component according to any of the preceding claims, wherein the chip carrier part (2) is thermally conductively connected to at least one cooling lug (15) which projects from the encapsulation (3) on a different side area (19) of the said encapsulation (3) from the connection parts (4, 5, 9).

9. Optoelectronic component according to any of the preceding claims, wherein the encapsulation (3) is composed completely of a radiation-transmissive material.

10. Optoelectronic component according to one of Claims 1 to 8, wherein a recess (11) is provided in the encapsulation (3) forming the base body (10), in which recess a radiation-transmissive window part (12) is arranged, and wherein the chip carrier part (2) is partially encapsulated by the radiation-opaque base body (10), the chips (1, 13) being arranged in the recess (11).

11. Optoelectronic component according to Claim 10, wherein the recess (11) is formed such that its profile is expanded in cross section outwards from within the encapsulation (3).

12. Optoelectronic component according to the preceding claim, wherein the inner area(s) of the recess (11) is/are formed as reflector for the radiation emitted by the chip (1, 13).

## Revendications

1. Dispositif optoélectronique, dans lequel au moins une première et au moins une deuxième puces optoélectroniques (1, 13) sont fixées sur une pièce de support de puce (2) d'un cadre conducteur (leadframe) (7), dans lequel le cadre conducteur (7) présente au moins une première et une deuxième pièces de raccordement (8, 12) disposés à distance de la pièce de support de puce (2), dans lequel la première pièce de raccordement (8) est raccordée de façon électriquement conductrice à un contact électrique de la première puce (1) et la deuxième pièce de raccordement (12) est raccordée de façon électriquement conductrice à un contact électrique de la deuxième puce (13), et dans lequel les puces optoélectroniques (1, 13) et chaque fois au moins une région partielle de la pièce de support de puce (2) et des pièces de raccordement (8, 12) sont enveloppées d'une gaine (3), de telle manière que des raccords externes (4, 5, 9, 14) de la pièce de support de puce (2) et des pièces de raccordement (8, 12) sortent de la gaine (3), dans lequel la pièce de support de puce (2) présente au moins deux raccords externes (4, 5), qui sortent de la gaine (3) en différents points de celle-ci présentant une distance l'un de l'autre, **caractérisé en ce que** la gaine (3) et les raccords externes (4, 5, 6, 9, 14) peuvent être montés en surface et **en ce que** les raccords externes (4, 5, 6, 9, 14) sont formés de telle manière que, dans un état du dispositif monté sur une plaquette de circuits imprimés prévue pour le montage du dispositif, ils soient tous disposés simultanément sur la plaquette de circuits imprimés.

2. Dispositif optoélectronique selon la revendication précédente, dans lequel la première puce optoélectronique (1) et la deuxième puce optoélectronique (13) sont aptes à s'éclairer dans des couleurs différentes.

3. Dispositif optoélectronique selon l'une quelconque des revendications précédentes, dans lequel les raccords externes (4, 5, 9, 14) de la pièce de support de puce (2) et des pièces de raccordement (8, 12), vus dans une vue en plan sur le cadre conducteur (7), s'étendent séparément les uns des autres à partir de la pièce de support de puce (2) à l'intérieur de la gaine (3) essentiellement en forme d'étoile vers l'extérieur.

4. Dispositif optoélectronique selon l'une quelconque des revendications précédentes, dans lequel les raccords externes (4, 5) de la pièce de support de puce (2) s'étendent en décalage essentiellement parallèle l'un à l'autre dans des directions opposées et sortent de la gaine (3) sur des faces latérales (18, 19) de celle-ci opposées l'une à l'autre, dans lequel les pièces de raccordement (8, 12) sont disposées sur des côtés différents de la pièce de support de puce (2) et dans lequel leurs raccords externes (9, 14) s'étendent parallèlement aux raccords externes (4, 5) de la pièce de support de puce (2) et sortent également de la gaine (3) sur des faces latérales (18, 19) de celle-ci opposées l'une à l'autre, de telle manière que les raccords externes (4, 5) de la pièce de support de puce (2) et les raccords externes (9, 14) des pièces de raccordement (8, 12) soient respectivement disposés en décalage diagonal l'un par rapport à l'autre.

5. Dispositif optoélectronique selon l'une quelconque des revendications précédentes, dans lequel, lors du fonctionnement des puces (1, 13), un rayonnement émis par celles-ci est envoyé ou reçu essentiellement par une face principale de la plaquette de circuits imprimés.

6. Dispositif optoélectronique selon l'une quelconque des revendications précédentes, qui présente exactement deux pièces de raccordement (8, 12) disposées à une distance de la pièce de support de puce (2) et exactement deux raccords externes (4, 5) de la pièce de support de puce (2).

7. Dispositif optoélectronique selon l'une quelconque des revendications précédentes, dans lequel le raccord externe (9, 14) de la pièce de raccordement (8, 12) est plus étroit que les raccords externes (4, 5, 6) de la pièce de support de puce (2) .

8. Dispositif optoélectronique selon l'une quelconque des revendications précédentes, dans lequel la pièce de support de puce (2) est reliée de façon thermiquement conductrice à au moins une ailette de refroidissement (15), qui sort de la gaine (3) sur une autre face (19) latérale de celle-ci que les pièces de raccordement (4, 5, 9).

9. Dispositif optoélectronique selon l'une quelconque des revendications précédentes, dans lequel la gaine (3) se compose entièrement d'un matériau perméable au rayonnement.

10. Dispositif optoélectronique selon l'une quelconque des revendications 1 à 8, dans lequel il est prévu un évidement (11) dans la gaine (3) formant le corps de base (10), dans lequel une pièce de fenêtre perméable au rayonnement (12) est disposée et dans lequel la pièce de support de puce (2) est en partie enveloppée par le corps de base (10) perméable au rayonnement, dans lequel les puces (1, 13) sont disposées dans l'évidement (11).

11. Dispositif optoélectronique selon la revendication 10, dans lequel l'évidement (11) est réalisé en s'élargissant en section transversale dans son tracé depuis l'intérieur de la gaine (3) vers l'extérieur.

12. Dispositif optoélectronique selon la revendication précédente, dans lequel la/les face(s) intérieure(s) de l'évidement (11) est/sont réalisées(s) comme réflecteur pour le rayonnement émis par la puce (1, 13).
